# EUROPÄISCHE PATENTSCHRIFT

(11) **EP 1 046 254 B1**
(45) Veröffentlichungstag und Bekanntmachung des Hinweises auf die Patenterteilung: **01.02.2006**
(21) Anmeldenummer: 98966166.5
(22) Anmeldetag: 25.11.1998
(51) Int. Cl.: H04L 1/00

(54) **VERFAHREN UND VORRICHTUNG ZUR CODIERUNG UND ÜBERTRAGUNG VON INFORMATIONEN, UNTER VERWENDUNG VON QUELLENGESTEUERTER KANALDECODIERUNG**
METHOD AND DEVICE FOR CODING AND TRANSMITTING INFORMATION, USING SOURCE-CONTROLLED CHANNEL DECODING
PROCEDE ET DISPOSITIF POUR LE CODAGE ET LA TRANSMISSION DE DONNEES, PAR DECODAGE DE VOIE A COMMANDE SOURCE

(30) Priorität: 07.01.1998 DE 19800339
(43) Veröffentlichungstag der Anmeldung: 25.10.2000
(73) Patentinhaber: SIEMENS AKTIENGESELLSCHAFT, 80333 München (DE)
(72) Erfinder: XU, Wen, D-85221 Dachau (DE)
(86) Internationale Anmeldenummer: PCT/DE1998/003469
(87) Internationale Veröffentlichungsnummer: WO 1999/035779

(56) Entgegenhaltungen:
- WO-A-97/14235
- XU W ET AL: "JOINT SOURCE-CHANNEL DECODING USING THE RESIDUAL REDUNDANCY IN COMPRESSED IMAGES" 1996 IEEE INTERNATIONAL CONFERENCE ON COMMUNICATIONS (ICC), CONVERGING TECHNOLOGIES FOR TOMORROW'S APPLICATIONS DALLAS, JUNE 23 - 27, 1996, Bd. 1, 23. Juni 1996, Seiten 142-148, XP000625657 INSTITUTE OF ELECTRICAL & ELECTRONICS ENGINEERS, New York, USA
- HAGENAUER J: "SOURCE-CONTROLLED CHANNEL DECODING" IEEE TRANSACTIONS ON COMMUNICATIONS, Bd. 43, Nr. 9, 1. September 1995, Seiten 2449-2457, XP000525669 INSTITUTE OF ELECTRICAL & ELECTRONICS ENGINEERS, New York, USA in der Anmeldung erwähnt

## Beschreibung

Die vorliegende Erfindung bezieht sich auf ein Verfahren zur Codierung von Informationen, insbesondere zur digitalen Übertragung oder Speicherung.

Quellensignale bzw. Quelleninformationen wie Sprach-, Ton-, Bild- und Videosignale beinhalten fast immer statistische Redundanz, also redundante Informationen. Durch eine Quellencodierung kann diese Redundanz stark verringert werden, so daß eine effiziente Übertragung bzw. Speicherung des Quellensignals ermöglicht wird. Diese Redundanzreduktion beseitigt vor der Übertragung redundante Signalinhalte, die auf der Vorkenntnis von z.B. statistischen Parametern des Signalverlaufs beruhen. Nach der Übertragung werden bei der Quellendecodierung diese Anteile dem Signal wieder zugesetzt, so daß objektiv kein Qualitätsverlust nachweisbar ist.

Aufgrund der unvollständigen Kenntnisse über die Quellensignale oder Einschränkungen bei der Komplexität des Quellencodierverfahrens ist die Quellencodierung üblicherweise nur suboptimal realisierbar, d.h. in den komprimierten Daten ist auch nach der Quellencodierung noch eine gewisse Redundanz vorhanden. Bei bisherigen Verfahren zur Quellencodierung werden die Quellensignale häufig zu Symbolen oder quantisierten Parametern komprimiert, welche dann entsprechend einer Zuordnungsvorschrift auf binäre Codewörter abgebildet werden, wobei die Zuordnungsvorschrift bisher mehr oder wenig zufällig gewählt wurde.

Auf der anderen Seite ist es üblich, bei der Signalübertragung, gezielt Redundanz durch Kanalcodierung wieder hinzuzufügen, um die Beeinflussung der Übertragung durch Kanalstörungen weitgehend zu beseitigen. Durch zusätzliche redundante Bits wird es somit dem Empfänger bzw. Decoder ermöglicht, Fehler zu erkennen und eventuell auch zu korrigieren.

Lange Zeit war es eine der grundlegenden Prämissen der Informationstheorie, daß die Quellencodierung und die Kanalcodierung unabhängig voneinander ausgeführt werden können, um ein optimales Ergebnis zu erzielen. Gemäß dieser Grundlage hängt die Auslegung des Quellen-Decodierers nur von den Quelleneigenschaften ab, wohingegen das Kanalcodierungsschema nur von den Kanaleigenschaften abhängen soll. Dieser Grundsatz kann richtig sein, wenn der Quellen-Codierer statistisch unabhängige und somit nicht korrelierte sowie gleich wahrscheinliche Symbole liefert und die Decodierverzögerung beliebig groß werden kann. In der praktischen Anwendung sind indessen in der Regel diese Voraussetzungen nicht erfüllt. Das Ausgangssignal, des Quellen-Codierers, bzw. die von ihm ausgegebenen Symbolfolgen weisen oft eine Restredundanz auf, und gleichzeitig ist die erlaubte Verzögerung insbesondere bei Sprachübertragung beschränkt.

Es ist bekannt, diese Restredundanz der quellencodierten Symbolfolgen bei der sogenannten quellengesteuerten Kanaldecodierung auszunutzen. Dabei wird der Decodiervorgang des Kanaldecoders einerseits durch die übertragenen Bits und andererseits durch eine A-priori-/A-posteriori-Information über den wahrscheinlichsten Wert einiger wichtiger. Quellenbits gesteuert. Die Quelleninformation hat also einen Einfluß auf das Ergebnis der Kanaldecodierung. Im Falle der Viterbi-Algorithmus-Decodierung wird dieses Verfahren als A-priori-Viterbialgorithmus bezeichnet. Bei Verwendung eines solchen Verfahrens ist eine Modifikation nur seitens des Empfängers notwendig. So lehrt die Druckschrift J. Hagenauer, "Source-controlled channel decoding", IEEE Trans. Commun., Band 43, Seiten 2449 - 2457, September 1995, bei der quellengesteuerten Kanaldecodierung die Inter-Rahmen-Korrelation, d.h. die statistische Abhängigkeit zwischen zeitlich und/oder örtlich benachbarten Signalsamples auszunutzen.

Untersuchungen haben auch ergeben, daß es - aufgrund der ungleichen Verteilung der Parameterwerte, die wiederum auf der Nichtstationarität der Quellensignale zurückzuführen ist - eine Restredundanz nicht nur zwischen Bits aufeinanderfolgender Rahmen, sondern auch zwischen den Bits eines Parameters innerhalb eines Rahmens gibt.

Die vorliegende Erfindung hat zur Aufgabe, eine Informationsübertragung oder Informationsspeicherung mit möglichst wenig Fehlern und möglichst geringem Aufwand zu erreichen.

Die oben genannte Aufgabe wird erfindungsgemäß durch die Merkmale der unabhängigen Ansprüche gelöst.

Die Druckschrift "Joint Source-Channel Decoding using the Residual Redundancy in Compressed Images" von Wen Xu et al. 1996, IEEE International Conference on Communications, Dallas, June 23-27, 1996, Vol.1 23. Juni 1996, seiten 142-148, offenbart den Oberbegriff des Anspruchs 1.

Die Erfindung beruht demnach auf dem Gedanken, eine Zuordnungsvorschrift zwischen Symbolen und binären Codewörtern gezielt derart zu wählen, daß die in den Symbolfolgen noch enthaltene redundante Information bei der Kanaldecodierung möglichst effizient genützt werden kann.

Durch die Erfindung wird erreicht, daß ohne Mehraufwand die Fehlerrate der decodierten Bits reduziert werden kann, und so Informationen mit weniger Störungen übertragen werden können.

Die Erfindung wird im folgenden anhand bevorzugter Ausführungsbeispiele näher beschrieben. Dabei wird besonders die digitale Übertragung der Informationen beschrieben. Dennoch ist die Erfindung auch zur Speicherung von Informationen anwendbar, da das Schreiben von Informationen auf ein Speichermedium und das Lesen von Informationen von einem Speichermedium hinsichtlich der vorliegenden Erfindung dem Senden von Informationen und dem Empfangen von Informationen entspricht.

Oft wird der Begriff "Decodierung" verwendet, um die Decodierung kanalcodierter Bitstellen zu beschreiben, während der Begriff "Detektion" verwendet wird, wenn allgemein über die binären Werte einer Bitstelle entschieden wird. Da die vorliegende Erfindung auf beide Fälle vorteilhaft anwendbar ist, beinhaltet im Rahmen der vorliegenden Patentanmeldung der Begriff "Decodierung" auch den Vorgang der Detektion.

Zur Erläuterung der Ausführungsformen der Erfindung dienen die nachstehend aufgelisteten Figuren.

Es zeigen:
- Figur 1: eine schematische Darstellung einer Nachrichtenübertragungskette
- Figur 2: eine schematische Darstellung des Zusammenhangs zwischen Symbolen und den quellencodierten Bitfolgen in einer Rahmenstruktur
- Figur 3: Häufigkeitsverteilung der Symbole und der binären Werte je nach binärer Abbildung

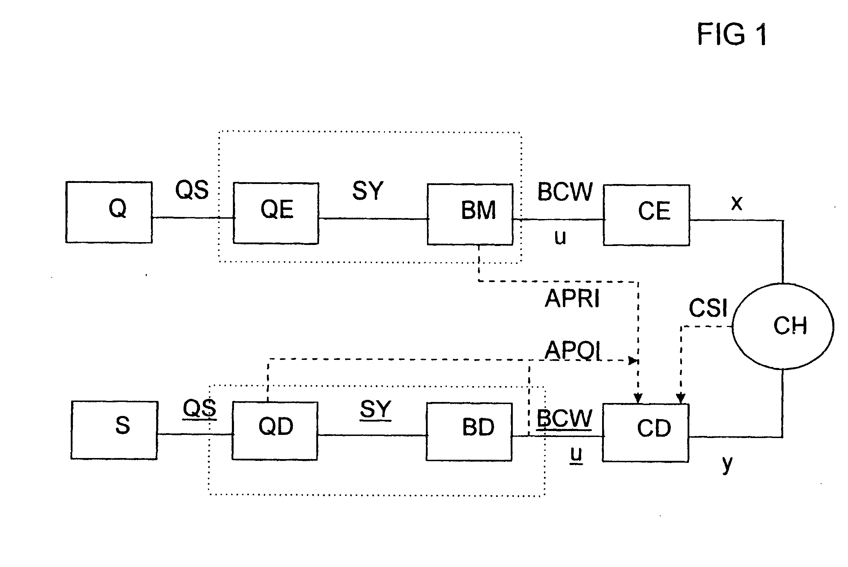

Figur 1 zeigt eine Quelle Q, die Quellensignale QS erzeugt, die von einem Quellencodierer QE, wie dem GSM fullrate Sprachcodierer, zu aus Symbolen bestehenden Symbolfolgen SY komprimiert werden. Die Symbole haben dabei einen der Werte c,j (Symbolwert) . Bei parametrischen Quellcodierverfahren werden die von der Quelle Q erzeugten Quellensignale QS (z.B. Sprache) in Blöcke unterteilt (z.B. zeitliche Rahmen) und diese getrennt verarbeitet. Der Quellencodierer QE erzeugt quantisierte Parameter (z.B. Sprachkoeffizienten), die im folgenden auch als Symbole einer Symbolfolge SY bezeichnet werden, und die die Eigenschaften der Quelle im aktuellen Block auf eine gewisse Weise widerspiegeln (z.B. Spektrum der Sprache, Filterparameter). Diese Symbole weisen nach der Quantisierung einen bestimmten Symbolwert c,j auf.

So erzeugt beispielsweise der GSM-Fullratecoder 76 Parameter, von denen die Parameter 0 bis 7 die sogenannten LAR-Koeffizienten (logarithmical area ratio) sind, die bei der LPC-Analyse erzeugt werden (linear prediction coding). Die Parameter Nr. 9, 26, 43 und 60 sind Ähnlichkeitsmaße für die sogenannte LTP (long term prediction).In jedem Rahmen gibt es außerdem vier X_{MAX}-Koeffizienten (bzw. -Parameter) aus der sogenannten RPE-Analyse (regular pulse exciting), die sich von Rahmen zu Rahmen nur wenig ändern.

Aufgrund der unvollständigen Kenntnisse über die Quellensignale oder Einschränkungen bei der Komplexität des Quellencodierverfahrens ist die Quellencodierung QE üblicherweise nur suboptimal realisierbar, d.h. in den komprimierte Informationenen enthaltenden Symbolfolgen SY ist noch redundante Information enthalten.

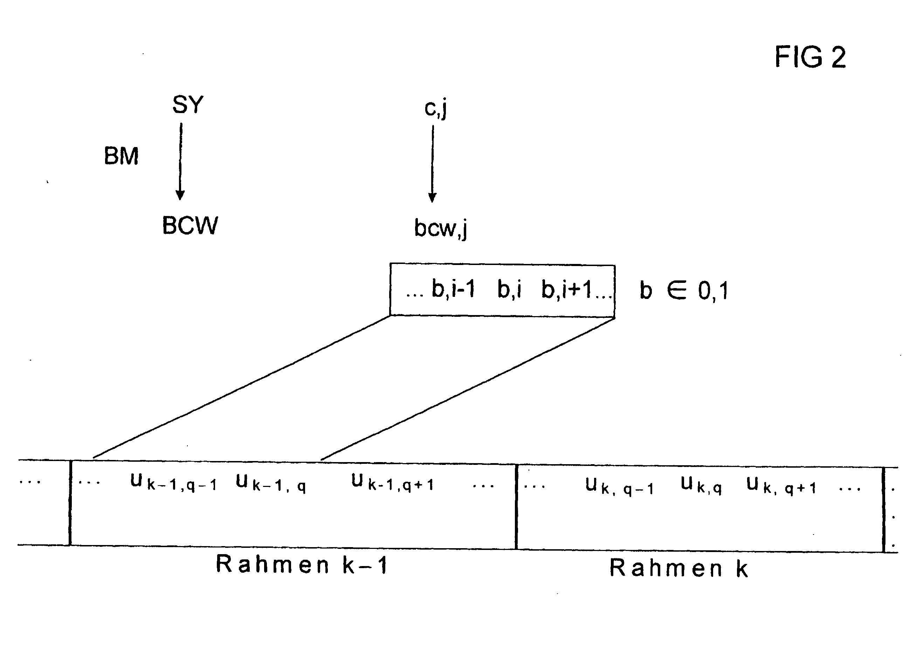

Die Symbole der Symbolfolge SY bzw. die entsprechenden Symbolwerte c,j werden wie in Figur 2 gezeigt durch eine binäre Abbildung BM (Zuordnungsvorschrift), die häufig als Teil der Quellencodierung QE beschrieben wird, auf eine Folge BCW binärer Codewörter bcw, j abgebildet, die jeweils mehrere Bitstellen b,i aufweisen. Es wird also jedem Symbolwert c,j ein anderes binäres Codewort bcw,j zugeordnet, die sich durch unterschiedliche binäre Werte an einer oder mehreren Bitstellen b,i unterscheiden. Dabei kennzeichnet der Index j die unterschiedlichen Werte der Symbole oder die unterschiedlichen Codewörter und die Indices i,k,q die Stelle an der ein entsprechender Wert steht. Werden diese binären Codewörter bcw,j beispielsweise nacheinander als Folge BCW binärer Codewörter weiterverarbeitet, so entsteht eine Folge u von quellencodierten Bitstellen u_{q}, die in einer Rahmenstruktur eingebettet sein können, wobei jede Bitstelle u_{q} fest einer bestimmten Bitstelle b,i eines bestimmten Codewortes bcw,j zugeordnet ist. So entsteht beispielsweise bei der GSM-Fullratecodierung alle 20 Millisekunden ein Rahmen mit 260 Bitstellen u_{q}. Figur 2 zeigt eine so entstehende Rahmenstruktur eines Rahmens k. Die quellencodierten Bitstellen u_{q} haben entweder den Wert "+1" oder "-1". Der Index 1 läuft innerhalb eines Rahmens von 0 bis Q-1, wobei Q die Anzahl von quellencodierten Bitstellen u_{q} in einem Rahmen ist.

In jedem Rahmen können die Bitstellen beispielsweise in drei Klassen mit unterschiedlicher Bedeutung und Sensitivität gegenüber Kanalstörungen eingeteilt werden. In einem Kanalcodierer CE, wie einem Faltungscodierer, erfolgt eine Codierung der quellencodierten Bitfolgen u gegen Kanalstörungen derart, daß die geringste Bit-Fehler-Wahrscheinlichkeit in der wichtigsten Klasse auftritt. Dazu werden zuerst die 50 wichtigsten Bits (Klasse 1a) durch 3 Bits einer zyklischen Blocksicherheit (CRC) gesichert. Die nächsten 132 wichtigen Bits (Klasse 1b) werden mit den zuvor genannten 53 Bits regruppiert und zusammen mit 4 Tail-Bits mit einer Rate 1/2 faltungscodiert. Die 78 weniger wichtigen Bits (Klasse 2) werden uncodiert übertragen.

Diese derart kanalcodierten Bitfolgen x werden in einem nicht dargestellten Modulator weiterverarbeitet und anschließend über eine Übertragungsstrecke CH übertragen. Bei der Übertragung treten Störungen auf, z.B. Fading, beschrieben durch einen Fadingfaktor aₖ, und Rauschen, beschrieben durch den Rauschfaktor N₀.

Die Übertragungsstrecke CH liegt zwischen einem Sender und einem Empfänger. Der Empfänger enthält gegebenenfalls eine nicht dargestellte Antenne zum Empfang der über die Übertragungsstrecke CH übertragenen Signale, eine Abtasteinrichtung, einen Demodulator zum Demodulieren der Signale und einen Entzerrer zum Eliminieren der Intersymbolstörungen. Diese Einrichtungen wurden ebenfalls aus Vereinfachungsgründen in Figur 1 nicht dargestellt. Auch ein mögliches Interleaving und Deinterleaving ist nicht dargestellt.

Der Entzerrer gibt Empfangswerte einer Empfangsfolge y aus. Die Empfangswerte haben aufgrund der Störungen bei der Übertragung über die Übertragungsstrecke CH Werte, die von "+1" und "-1" abweichen, z.B. "+0,2" oder "-3,7".

In einem Kanaldecodierer CD wird die Kanalcodierung rückgängig gemacht. Dazu wird auf der Basis der Empfangswerte der Empfangsfolge y über die binären Werte der einzelnen empfangenen Bitstellen u_{q} bzw. b,i entschieden. Neben den Kanalzustandsinformationen CSI kann dabei die oben erklärte Restredundanz der Symbolfolgen SY bei der sogenannten quellengesteuerten oder gemeinsamen Kanaldecodierung CD ausgenutzt werden, um Bitfehler zu korrigieren bzw. die Decodierung zu verbessern. Hierzu gibt es prinzipiell zwei Möglichkeiten:
- Im Sinne einer A-Priori-Information APRI wird die redundante Information über die Häufigkeit der Symbolwerte c,j und somit auch der Häufigkeit der binären Werte bestimmter Bitstellen b,i und die Korrelation der Symbole untereinander und somit auch der Korrelation der binären Werte bestimmter Bitstellen b,i untereinander im Kanaldecodierer CD direkt genutzt, indem beispielsweise diese Information zuvor in einem Testquellcodierer bzw. mittels eines Testquellcodierers durch einige Testquellsignale ermittelt wird, und dann diese Information im Kanaldecodierer CD abgespeichert wird und zur Kanaldecodierung ausgenützt wird, indem sie beispielsweise zur Bestimmung einer Schwelle, ab der beispielsweise auf den binären Wert "1" entschieden wird verwendet wird.
- Die redundante Information über die Häufigkeit der Symbolwerte c,j und somit auch der Häufigkeit der binären Werte bestimmter Bitstellen b,i und die Korrelation der Symbole untereinander und somit auch der Korrelation der binären Werte bestimmter Bitstellen b,i untereinander wird im Sinne einer A-Posteriori-Information nach der Kanaladecodierung CD ermittelt. Die A-Posteriori-Information APOI- kann dabei direkt nach dem Kanaldecodierer CD oder nach der bzw. während der Quellendecodierung QD ermittelt werden.

Ein derartiges Verfahren ist in "J. Hagenauer, "Source-controlled channel decoding," *IEEE Tran.* Commun., vol. 43, pp. 2449-2457, Sept. 1995", insbesondere auf den Seiten 2451 und 2452 beschrieben, wobei der Decodiervorgang des Kanaldecoders sowohl durch die übertragenen Codebits als auch durch eine A-Priori-/A-Posteriori-Information über den wahrscheinlichen Wert einiger wichtiger Quellenbits gesteuert wird. Im Falle der VA-(Viterbi-Algorithmus) Decodierung wurde diese Methode als Apri-VA bezeichnet.

Zur Kanaldecodierung CD kann beispielsweise auch ein SOVA (Weichausgangs (Soft-Output)-Viterbi-Algorithmus) verwendet werden. Ein SOVA ist dabei ein Algorithmus, der nicht nur einen Entscheidungswert ausgibt, sondern weiterhin auch angibt, mit welcher Wahrscheinlichkeit der entschiedene Wert vorliegt.

Nach erfolgter Kanaldecodierung CD erfolgt eine Rückabbildung DB der empfangenen kanaldecodierten Bitfolgen u bzw. der darin enthaltenen binären Codewörter bcw, j auf empfangene Symbole von empfangenen Symbolfolgen SY, welche anschließend bei der Quellendecodierung QD in Quellensignale QS verarbeitet werden und an der Informationssinke S ausgegeben werden.

Bei bisher bekannten Verfahren zur Quellencodierung wurden die Symbole im allgemeinen nach der Quellencodierung QE und - quantisierung durch den natural binary code NBC dargestellt. Die quellengesteuerte Kanaldecodierung CD wurde folglich auch nur auf derart quellencodierte Bitstellen b,i angewandt. Wenn in den Symbolen bzw. den aus Symbolen bestehenden Symbolfolgen SY noch redundante Informationen vorhanden sind, d.h. die relativen Häufigkeiten der Symbolwerte c,j ungleich verteilt sind, oder einige Symbole miteinander korreliert sind, so existiert automatisch auch eine redundante Information in einigen Bitstellen b,i.

Es stellte sich bei aufwendigen Simulationen mit eigens für diesen Zweck entwickelten Simulationsverfahren heraus, daß aufgrund der ungleichen Verteilung der Symbolwerte c,j durch die gezielte Verwendung bestimmter binärer Abbildungen BM die in den Symbolfolgen SY enthaltene Restredundanz bei der Kanaldecodierung CD besonders gut zur Verbesserung der Fehlerkorrektur ausgenützt werden kann.

Die vorliegende Erfindung nützt die in der Symbolfolge SY vorhandene Restredundanz besonders gut zur Decodierung der binären Werte der Bitstellen bzw. der Bitstellen b,i, indem nicht irgendeine zufällig gewählte Abbildung BM gewählt wird, sondern gezielt solche binären Abbildungen BM, bei denen die aus Symbolfolgen SY bestehenden Informationen derart auf binäre Codewörter bcw,j mit jeweils einer Mehrzahl von Bitstellen b,i abgebildet werden, daß die in den Symbolfolgen SY enthaltene redundante Information eine Information über die binären Werte einer bzw. einiger dieser binären Stellen repräsentiert.

Bei einer Ausführungsvariante werden die aus Symbolfolgen SY bestehenden Informationen derart auf binäre Codewörter bcw,j mit jeweils einer Mehrzahl von Bitstellen b,i abgebildet, daß wenigstens für eine bzw. einige der Bitstellen b,i die relativen Häufigkeiten der dieser Bitstelle bzw. diesen Bitstellen b,i entsprechenden binären Werte die relativen Häufigkeiten der binär zu codierenden Symbolwerte c,j zum Ausdruck bringt.

Eine andere Ausgestaltung sieht vor, daß die aus Symbolfolgen SY bestehenden Informationen derart auf binäre Codewörter bcw,j mit jeweils einer Mehrzahl von Bitstellen b,i abgebildet werden, daß Codewörter bcw,j, die Symbolwerten c,j zugeordnet sind, die eine große relative Häufigkeit aufweisen, an einer bzw. einigen der Bitstellen b,i, insbesondere den wichtigen Bitstellen gleiche binäre Werte aufweisen.

Beispielsweise erfolgt die Zuordnung derart, daß die beiden Symbole c,j, die am häufigsten vorkommen an der wichtigsten Bitstelle b,i bzw. den wichtigsten Bitstellen den gleichen binären Wert aufweisen. So kann die Entscheidung über den binären Wert an der wichtigsten Bitstelle b,i bzw. den wichtigsten Bitstellen zuverlässiger getroffen werden.

Je effizienter die binäre Abbildung der Symbolredundanz auf die individuelle Bitstellenredundanz ist, desto mehr redundante Informationen sind über die binären Werte der einzelnen Bitstellen b,i zur Fehlerkorrektur ausnutzbar. Die Effizienz der Redundanzkonvertierung hängt dabei nicht nur von der Art der binären Abbildung BM ab, sondern auch von der Art der redundanten Information im Quellensignal QS.

Im folgenden werden 4 unterschiedliche binäre Abbildungen BM vorgestellt:
- Natural binary code NBC
- Folded binary code FBC
- Gray binary code GBC
- Minimum distance code MBC

Diese 4 binären Abbildungen sind in der folgenden Tabelle exemplarisch mit jeweils 4 Bitstellen dargestellt:

| Symbol c,j | Codewort bcw,j NBC | | | | Codewort bcw,j FBC | | | | Codewort bcw,j GBC | | | | Codewort bcw,j MDC | | | |
|---|---|---|---|---|---|---|---|---|---|---|---|---|---|---|---|---|
| | *b*3 | *b*2 | *b*1 | *b*0 | *b*3 | *b*2 | *b*1 | *b0* | *b*3 | *b*2 | *b*1 | *b*0 | *b*3 | *b*2 | *b*1 | *b*0 |
| *C*₀ | 0 | 0 | 0 | 0 | 0 | 1 | 1 | 1 | 0 | 0 | 0 | 0 | 0 | 1 | 1 | 1 |
| *C*₁ | 0 | 0 | 0 | 1 | 0 | 1 | 1 | 0 | 0 | 0 | 0 | 1 | 0 | 1 | 1 | 0 |
| *C*₂ | 0 | 0 | 1 | 0 | 0 | 1 | 0 | 1 | 0 | 0 | 1 | 1 | 0 | 1 | 0 | 1 |
| *C*₃ | 0 | 0 | 1 | 1 | 0 | 1 | 0 | 0 | 0 | 0 | 1 | 0 | 0 | 0 | 1 | 1 |
| *C*₄ | 0 | 1 | 0 | 0 | 0 | 0 | 1 | 1 | 0 | 1 | 1 | 0 | 0 | 1 | 0 | 0 |
| *C*₅ | 0 | 1 | 0 | 1 | 0 | 0 | 1 | 0 | 0 | 1 | 1 | 1 | 0 | 0 | 1 | 0 |
| *C*₆ | 0 | 1 | 1 | 0 | 0 | 0 | 0 | 1 | 0 | 1 | 0 | 1 | 0 | 0 | 0 | 1 |
| *C*₇ | 0 | 1 | 1 | 1 | 0 | 0 | 0 | 0 | 0 | 1 | 0 | 0 | 0 | 0 | 0 | 0 |
| *C*₈ | 1 | 0 | 0 | 0 | 1 | 0 | 0 | 0 | 1 | 1 | 0 | 0 | 1 | 0 | 0 | 0 |
| *C*₉ | 1 | 0 | 0 | 1 | 1 | 0 | 0 | 1 | 1 | 1 | 0 | 1 | 1 | 0 | 0 | 1 |
| *C*₁₀ | 1 | 0 | 1 | 0 | 1 | 0 | 1 | 0 | 1 | 1 | 1 | 1 | 1 | 0 | 1 | 0 |
| *C*₁₁ | 1 | 0 | 1 | 1 | 1 | 0 | 1 | 1 | 1 | 1 | 1 | 0 | 1 | 1 | 0 | 0 |
| *C*₁₂ | 1 | 1 | 0 | 0 | 1 | 1 | 0 | 0 | 1 | 0 | 1 | 0 | 1 | 0 | 1 | 1 |
| *C*₁₃ | 1 | 1 | 0 | 1 | 1 | 1 | 0 | 1 | 1 | 0 | 1 | 1 | 1 | 1 | 0 | 1 |
| *C*₁₄ | 1 | 1 | 1 | 0 | 1 | 1 | 1 | 0 | 1 | 0 | 0 | 1 | 1 | 1 | 1 | 0 |
| *C*₁₅ | 1 | 1 | 1 | 1 | 1 | 1 | 1 | 1 | 1 | 0 | 0 | 0 | 1 | 1 | 1 | 1 |
| # (Bitwe chsel) | 1 | 3 | 7 | 15 | 1 | 2 | 6 | 14 | 1 | 2 | 4 | 8 | 1 | 6 | 10 | 10 |

Gemäß der Erfindung wird der Gray Binary Code verwendet.

Um die in quellencodierten Symbolfolgen SY vorhandene Restredundanz gegen Kanalstörungen effizient zu nutzen, wird im folgenden ein Verfahren basierend auf gezielter binärer Abbildung BM dargestellt.

Die quellencodierten Symbolfolgen SY werden auf eine geeignete binäre Repräsentation (wie z.B. den FBC (folded binary code) oder GBC(Gray Binary Code)) abgebildet und erst dann zum Kanalcodierer CE übermittelt. Zur Implementierung der Erfindung in bereits bestehende Systeme, die als binäre Abbildung den NBC verwenden, werden die Bits der quellencodierten Symbolfolgen SY im NBC- (natural binary code) Format zuerst auf eine geeignete binäre Repräsentation (wie z.B. den FBC (folded binary code) oder GBC (Gray Binary Code) ) umgewandelt und erst dann zum Kanalcodierer CE übermittelt.

Auf der Empfangsseite ist es genau umgekehrt, d.h. nach der Kanaldecodierung CD werden die Bitfolgen u entsprechend der binären Abbildung zurück abgebildet BD und dann an den Quellendecoder QD weitergegeben.

Bei der quellengesteuerten Kanaldecodierung CD kann nun die in den quellencodierten Symbolfolgen SY vorhandene Restredundanz (ungleiche Verteilung und Korrelation) leichter und effizienter genutzt werden, da die in der Symbolebene vorhandene Redundanz dadurch in eine in der Bitebene vorhandene Redundanz (ungleiche Verteilung und Korrelation) umgewandelt wird, die vom quellengesteuerten Kanaldecoder (z.B. Apri-VA) direkt verwendet werden kann. Mit diesem Verfahren erzielt man eine verbesserte Qualität bei der Übertragung der Quellensignale QS(Ton, Sprache, etc.). Der zusätzliche Rechenaufwand für eine derartige binäre Abbildung BM ist gering und kann üblicherweise vernachlässigt werden.

Eine solche binäre Abbildung BM kann implizit im Quellenencoder und -decoder integriert werden. Für bereits standardisierte Codecs wie GSM Fullrate/Enhanced Fullrate Sprachcodec bedeutet sie jedoch eine Modifizierung sowohl im Empfänger als auch im Sender. Allerdings ist diese Modifizierung ohne große Hardwareänderung möglich. Beim GSM System ist von der Infrastrukturseite nur eine Hinzufügung der binären Abbildung und inversen Abbildung in dem TRAU (transcoder and rate adaptor unit) nötig, die BTS (base transceiver station), BSC (base station controller), etc. bleiben unverändert.

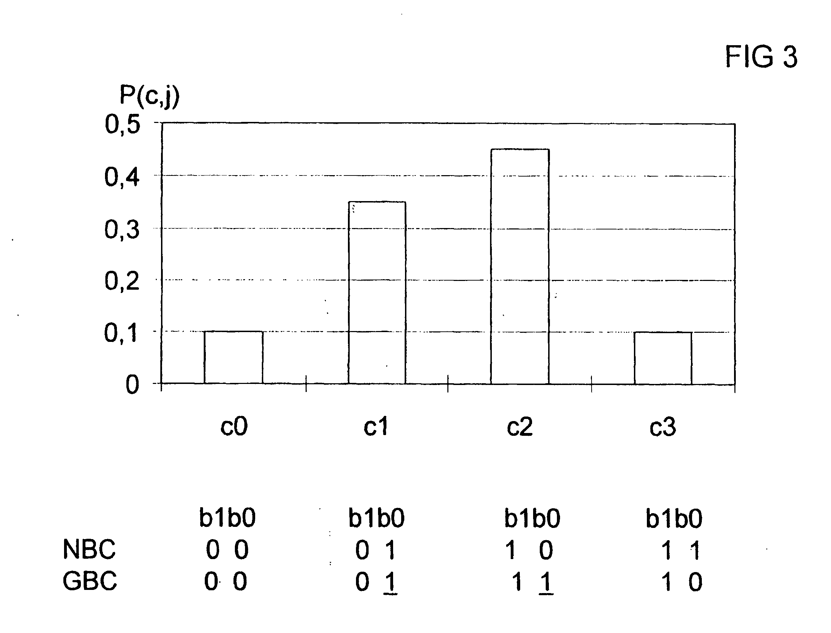

Figur 3 zeigt die Häufigkeitsverteilung der Symbolwerte c,j und die zugeordneten binären Codewörter bcw,j. Dabei ist zu sehen, daß im Falle des GBC an der zweiten Bitstelle b0 die Wahrscheinlichkeit für den binären Wert "1" sehr viel größer ist als der für den binären Wert "0", insbesondere unter der Bedingung, daß das Symbol c1 oder c2 gesendet wurde. Diese Information kann bei der quellengesteuerten Kanaldecodierung im Sinne einer A-Posteriori oder A-Priori Information genützt werden, um über den binären Wert der Bitstelle b0 zu entscheiden, bzw, die dazu verwendete Schwelle zu bestimmen, und so die Entscheidung zuverlässiger zu machen.

Die Decodierung kann also noch verbessert werden, wenn auch eine Information über den wahrscheinlich übertragenen Symbolwert c,j verwendet wird.

Hätte man bei der binären Abbildung den NBC verwendet, so wäre die bei der quellengesteuerten Kanaldecodierung verwendete A-Posterioi oder A-Priori Information (d.h. die Wahrscheinlichkeit für den binären Wert "1") viel kleiner und die Decodierung der Bitstellen könnte nicht so zuverlässig durchgeführt werden.

Gemäß der Erfindung wird die aus Symbolfolgen SY bestehenden Information derart auf binäre Codewörter bcw,j mit jeweils einer Mehrzahl von Bitstellen b,i abgebildet, daß die Korrelation zwischen den binären Werten der entsprechenden Bitstellen b,i,k (oder in der Rahmenebene u_{q,k}) und b, i, k+1 (oder in der Rahmenebene u_{q,k+1} ) aufeinanderfolgender Rahmen k, k+1 groß ist.

Dabei wird insbesondere eine Korrelation der Quellenbits berücksichtigt. Die grundlegende Idee dieses Verfahrens besteht dabei darin, daß sich entsprechende Symbole zwischen zwei aufeinanderfolgenden Rahmen nicht sehr oft ändern und somit eine Redundanz bei der übertragung vorliegt. Diese Korrelation zwischen aufeinanderfolgenden Rahmen kann empfängerseitig unter Verwendung eines APRI-SOVA (A-priori-Weichausgangs-Viterbi-Algorithmus)-Decodierers besonders gut ausgenutzt werden, wenn eine binäre Abbildung BM derart gewählt wird, daß die Korrelation zwischen den binären Werten der entsprechenden Bitstellen aufeinanderfolgender Rahmen groß ist.

Bei quellengesteuerter Kanaldecodierung CD kann auch die Inter-Rahmen-Korrelation, d.h. die statistische Abhängigkeit zwischen zeitlich und/oder örtlich benachbarten Signalsamples genutzt werden. Zur Schätzung der A-Priori-/A-Posteriori-Information kann man beispielsweise den empirischen "HUK-Algorithmus", der in "J. Hagenauer, "Source-controlled channel decoding," *IEEE Tran.* Commun., vol. 43, pp. 2449-2457, Sept. 1995" beschrieben ist oder ein auf Kalman-Filter basierende Verfahren zur quellengesteuerten Kanaldecodierung verwenden.

Bei einer weiteren Ausführungsvariante werden die aus Symbolfolgen SY bestehenden Informationen derart auf binäre Codewörter bcw,j mit jeweils einer Mehrzahl von Bitstellen b,i abgebildet, daß bei einem falsch detektiertem binären Wert, der Fehler im detektierten Symbol bzw. dem ausgegebenen Quellensignal QS klein ist. Durch eine geeignete binäre Abbildung BM werden so die Quellensignale weniger empfindlich auf Kanalstörungen reagieren als bei dem üblicherweise verwendeten NBC.

Es sind auch Ausführungsvarianten denkbar, bei denen die binäre Abbildung BM so gewählt ist, daß mehrere Aspekte der oben beschriebenen Varianten in der Form eines Kompromisses berücksichtigt werden.

So stellte sich bei aufwendigen Simulationen besonders die Verwendung des GBC oder des FBC als binäre Abbildung als besonders vorteilhaft heraus, insbesondere wenn die Symbole eine gaußsche oder eine anti-gaußsche Verteilung besitzen, was in vielen Fällen der Fall ist.

Zur Durchführung der oben erklärten Verfahren ist ein beispielsweise in einem Funkgerät integrierter softwaregesteuerter Signalprozessor vorgesehen, der zu übertragende Informationen nach einem der oben beschriebenen Verfahren codiert und/oder decodiert.

## Patentansprüche

1. Verfahren zur Codierung von Informationen, bei dem die aus Symbolfolgen (SY) bestehenden Informationen derart auf binäre Codewörter (bcw,j) mit jeweils einer Mehrzahl von Bitstellen (b,i) abgebildet werden, die in aufeinander folgende Rahmen eingebettet sind, dass die in den Symbolfolgen (SY) enthaltene redundante Information eine Information über die binären Werte einer bzw. einiger dieser Bitstellen (b,i) repräsentiert,
wobei die Korrelation zwischen den binären Werten der entsprechenden Bitstellen (b,i) aufeinander folgender Rahmen groß ist,
**dadurch gekennzeichnet, dass** die aus Symbolfolgen (SY) bestehenden Informationen auf binäre Codewörter (bcw.j) des Gray Binary Codes abgebildet werden.

2. Verfahren nach Anspruch 1, bei dem die aus Symbolfolgen (SY) bestehenden Informationen derart auf binäre Codewörter (bcw,j) mit jeweils einer Mehrzahl von Bitstellen (b,i) abgebildet werden, dass wenigstens für eine bzw. einiger der Bitstellen (b,i) die relativen Häufigkeiten der dieser Bitstelle (b,i) bzw. diesen Bitstellen (b,i) entsprechenden binären Werte die relativen Häufigkeiten der binär zu codierenden Symbolwerte (c,j) zum Ausdruck bringen.

3. Verfahren nach einem der vorhergehenden Ansprüche, bei dem die aus Symbolfolgen (SY) bestehenden Informationen derart auf binäre Codewörter (bcw,j) mit jeweils einer Mehrzahl von Bitstellen (b,i) abgebildet werden, dass Codewörter (bcw,j), die Symbolwerten (c,j) zugeordnet sind, die eine große relative Häufigkeit aufweisen, an einer bzw. einigen der Bitstellen (b0) gleiche binäre Werte aufweisen.

4. Verfahren nach einem der vorhergehenden Ansprüche, bei dem die aus Symbolfolgen (SY) bestehenden Informationen derart auf binäre Codewörter (bcw,j) mit jeweils einer Mehrzahl von Bitstellen (b,i) abgebildet werden, dass im Falle einer falsch decodierten Bitstelle (b,i) der Fehler im empfangenen Quellensignal (QS) klein ist.

5. Verfahren nach einem der vorhergehenden Ansprüche, bei dem die Symbolfolgen (SY) aus einer Quellencodierung (QE) hervorgehen.

6. Verfahren zur Übertragung von Informationen, bei dem die Informationen nach einem der Ansprüche 1 bis 5 codiert werden und die in den Symbolfolgen (SY) enthaltene redundante Information bei der Decodierung der Informationen verwendet wird.

7. Signalprozessor mit Mitteln zur Codierung von Informationen nach einem der Ansprüche 1 bis 5.

8. Funkgerät mit einem Signalprozessor mit Mitteln zur Codierung von Informationen nach einem der Ansprüche 1 bis 5 und Mitteln zur Decodierung von Informationen derart, dass die in den Symbolfolgen (SY) enthaltene redundante Information bei der Decodierung der Informationen verwendet wird.

## Claims

1. Method for encoding of information, in which the information consisting of symbol sequences (SY) is mapped onto binary codewords (bcw,j) each with a plurality of bit positions (b.i) which are embedded into consecutive frames such that the redundant information contained in the symbol sequences (SY) represents information about the binary values of one or of a few of these bit positions (b.i), with the correlation between the binary values of the corresponding bit positions (b.i) of consecutive frames being great,
**characterized in that** the information consisting of symbol sequences (SY) is mapped onto binary codewords (bcw.j) of the Gray Binary Code.

2. Method in accordance with claim 1, in which the information consisting of symbol sequences SY is mapped onto binary codewords bcw,j each with a plurality of bit positions b.i such that, at least for one or for a few of the bit positions (b.i) the relative frequencies of the binary value corresponding to this bit position (b.i) or these bit positions b.i express the relative frequencies of the symbol values c,j to be binary coded.

3. Method in accordance with one of the previous claims, in which the information consisting of symbol sequences SY is mapped onto binary codewords (bcw,j) each with a plurality of bit positions (b.i) such that codewords (bcw,j), which are assigned symbol values (c,j) which exhibit a large relative frequency feature the same binary values at one or at a few of the bit positions (b0).

4. Method in accordance with one of the previous claims, in which the information consisting of symbol sequences SY is mapped onto binary codewords (bcw,j) each with a plurality of
bit positions (b.i) such that, in the case of an incorrectly coded bit position (b.i) the error in the received source signal (QS) is small.

5. Method in accordance with one of the previous claims, in which the symbol sequences (SY) originate from source encoding (QE).

6. Method for transmission of information, in which the information is encoded in accordance with one of the claims 1 to 5 the redundant information contained in the symbol sequences (SY) is used in the decoding of the information.

7. Signal processor with means for encoding information in accordance with one of the claims 1 to 5.

8. Radio device with a signal processor with means for encoding information in accordance with one of the claims 1 to 5 and means for decoding information such that the redundant information contained in the symbol sequences (SY) is used for the decoding of the information.

## Revendications

1. Procédé de codage d'informations, dans lequel les informations composées de suites de symboles (SY) sont appliquées sur des mots de code binaires (bcw, j) avec respectivement une pluralité de positions de bits (b, i) qui sont insérées dans des trames successives de telle manière que l'information redondante contenue dans les suites de symboles (SY) représente une information sur les valeurs binaires d'une resp. de quelques-unes de ces positions de bits (b, i), la corrélation entre les valeurs binaires des positions de bits (b, i) correspondantes de trames successives étant grande, **caractérisé en ce que** les informations composées de suites de symboles (SY) sont appliquées sur des mots de code binaires (bcw, j) du code binaire de Gray (Gray Binary Code).

2. Procédé selon la revendication 1, dans lequel les informations composées de suites de symboles (SY) sont appliquées sur des mots de code binaires (bcw, j) avec respectivement une pluralité de positions de bits (b, i) de telle manière que, au moins pour une resp. quelques-unes des positions de bits (b, i), les fréquences relatives des valeurs binaires correspondant à cette position de bit (b, i) resp. à ces positions de bits (b, i) expriment les fréquences relatives des valeurs de symboles (c, j) à coder binairement.

3. Procédé selon l'une des revendications précédentes, dans lequel les informations composées de suites de symboles (SY) sont appliquées sur des mots de code binaires (bcw, j) avec respectivement une pluralité de positions de bits (b, i) de telle manière que des mots de code (bcw, j) affectés à des valeurs de symbole (c, j) qui présentent une grande fréquence relative présentent de mêmes valeurs binaires en l'une resp. quelques-unes des positions de bits (b0).

4. Procédé selon l'une des revendications précédentes, dans lequel les informations composées de suites de symboles (SY) sont appliquées sur des mots de code binaires (bcw, j) avec respectivement une pluralité de positions de bits (b, i) de telle manière que, dans le cas d'une position de bit (b, i) mal décodée, l'erreur dans le signal source (QS) reçu est petite.

5. Procédé selon l'une des revendications précédentes, dans lequel les suites de symboles (SY) résultent d'un codage de source (QE).

6. Procédé de transmission d'informations, dans lequel les informations sont codées selon l'une des revendications 1 à 5 et l'information redondante contenue dans les suites de symboles (SY) est utilisée lors du décodage des informations.

7. Processeur de signaux avec des moyens de codage d'informations selon l'une des revendications 1 à 5.

8. Appareil radio comprenant un processeur de signaux avec des moyens de codage d'informations selon l'une des revendications 1 à 5 et des moyens de décodage d'informations de manière telle que l'information redondante contenue dans les suites de symboles (SY) est utilisée lors du décodage des informations.
